# EUROPEAN PATENT SPECIFICATION

(11) **EP 3 969 963 B1**
(45) Date of publication and mention of the grant of the patent: **09.08.2023**
(21) Application number: 20722523.6
(22) Date of filing: 24.04.2020
(51) Int. Cl.: G03F 7/20, B29C 64/124, B33Y 10/00

(54) **SYSTEM AND METHOD FOR EXPOSING A MATERIAL WITH IMAGES**
SYSTEM UND VERFAHREN ZUM BELICHTEN EINES MATERIALS MIT BILDERN
SYSTÈME ET PROCÉDÉ D'EXPOSITION D'UN MATÉRIAU À DES IMAGES

(30) Priority: 16.05.2019 NO 20190617
(43) Date of publication of application: 23.03.2022
(73) Proprietor: VISITECH AS, 3003 Drammen (NO)
(72) Inventor: KIRKHORN, Endre, 3031 Drammen (NO); JØRGENSEN, Trond, 3018 Drammen (NO); DAAE, John, 1387 Asker (NO)
(74) Representative: Onsagers AS
(86) International application number: PCT/EP2020/061421
(87) International publication number: WO 2020/229137

(56) References cited:
- EP-A1- 1 666 235
- WO-A1-2017/100811
- US-A1- 2017 246 796
- US-A1- 2018 250 881

## Description

The present invention relates to a process to eliminate undesired non-continuous effects in adjacent exposure stripes when using a device for exposing a photo polymerizable (and other materials) for solidification of material layer by layer to build a 3D object or for 2D direct imaging lithography where only one layer is polymerized or exposed. Typical usage will be in 3D printers, rapid prototyping machines, rapid manufacturing machines and similar layer-by-layer building process equipment, in addition to 2D direct lithography machines to be used for lithography related to manufacturing of PCB, touch panels, solar cells, chemical milling and others.

### BACKGROUND

When two adjacent exposure stripes are placed close together, the polymerized material will depend on the positioning of the exposure stripes and the power in each stripe. If the positioning of the exposure stripes is well aligned in x and y direction relative to each other (i.e. on the same grid as the image pixels) and power is identical in the exposure stripes, the result will be optimum. The adjacent exposure stripes can then be placed close to each other ("back to back") or with an overlap zone which fits to the image pixel grid. If an overlap zone is applied, the image data in the overlap zone must be removed on one of the image data sets to avoid overexposure.

However, if the power distribution over the image orthogonal to the image stripe length has a certain variation, or if the image positioning for each exposures stripe is not on the pixel grid, the polymerized material will have undesired properties such as discontinuities or non-exposed areas.

US 2017/246796, which relates to a method for the production of three-dimensional objects, discloses generating illuminated single images of a motif in an illuminated field through a superimposition of extracted single images of the motif and a motif of switched-off light points.

WO2016/124634 describes a method for exposing a photo polymerizable material for solidification of material layer by layer to build a 3D object. The exposure is performed by dividing the image to be exposed into a number of sub images with an internal distance of at least one pixel and exposing the sub images sequentially onto the photo polymerizable material by means of a light projector.

EP3040778 describes a method for providing uniform brightness from a light projector on an image area. The document does not solve the problem of reducing the effect on the exposed result in the edge portion of adjacent exposure stripes which is caused by the difference in image position and/or difference in brightness uniformity on two adjacent exposure stripes.

### SUMMARY OF THE INVENTION

The object of the invention is to provide a system and method for exposing a photosensitive or photo polymerizable material layer by layer to build a 3D object or for 2D direct imaging lithography, which reduces or eliminates the undesired effects of prior art described above.

It is thus an object of the invention to provide a system and method capable of reducing the effect on the exposed result in the edge portion of adjacent exposure stripes which is caused by the difference in image position and/or difference in brightness uniformity on two adjacent exposure stripes.

The system and method of the invention will ease the requirement for brightness uniformity in the exposed image and also ease the tolerances for the mechanics that controls the image position inside the machine. When such parameter tolerances are eased, it is easier to provide a cost-effective machine as both brightness uniformity and image positioning mechanics requires expensive machine components.

The object of the invention is achieved by means of the features of the patent claims.

In one embodiment, the system for exposing a material with images comprises an exposure table and an electronic light projector arranged above the exposure table. The electronic light projector is adapted to project images towards a material arranged at the exposure table, where the electronic light projector and the exposure table are configured to be moved relative each other during exposure and where the electronic light projector is connected to a projector control unit. The projector control unit is configured to provide a sequence of images to be exposed, where the images are represented by image data and superimpose a static image pattern onto the edge sections of the images to be exposed, where the width of the static image pattern is slimmer than the image to be exposed, resulting in a sequence of combined images, and where the electronic light projector is configured to expose the combined images sequentially onto the material.

The projector control unit may also be configured to control the superimposition of the static image pattern onto the images to be exposed.

This system provides a resulting exposure at the material which provides good uniformity in the overlap zones between adjacent images.

In one embodiment are the images to be exposed in form of CAD (Computer aided design) image data, for example stored on a CAD data file. The static image pattern is then superimposed on to the data pattern given by the image data file on each side of the image area.

The material to be exposed by the electronic light projector is for example a photosensitive or photo polymerizable material. In the latter case, the system may be used for 3D printing as described earlier.

The electronic light projector is in one embodiment connected to a motor controller which provides a synchronization signal to the electronic light projector for controlling the movement of the electronic light projector relative to the exposure table. This movement enables the projector to set up the next image in an image sequence.

In one embodiment the superimposed pattern is fixed while the image data is sequentially presented. This means that the images that are projected onto the material to be exposed changes over the exposure area in order to form the complete picture/object. However, the superimposed pattern's function is to smooth the transitions between adjacent images, and may be fixed, ie. the image data of the superimposed pattern is the same for each image in the sequence.

In one embodiment the superimposed pattern on one side of the exposure stripe is complementary to the other side of the adjacent exposure stripe.

The superimposed pattern may have a width between a full projected image width and one projected image pixel. In accordance with the invention, the width is slimmer than the full projected image. The length of the superimposed pattern can for example be corresponding to the number of rows in one projected image, ie. have the same length as each image in a sequence.

The superimposed pattern can have different shapes, such as for example sawtooth shaped or stepped sawtooth shaped, or any other suitable shape.

Corresponding to the above description, a method for exposing a material with images comprises in one embodiment the following steps:
- providing a sequence of images to be exposed,
- superimposing a static image pattern onto the edge sections of the images to be exposed, where the width of the static image pattern is slimmer than the image to exposed, resulting in a sequence of combined images,
- exposing the combined images sequentially onto the material by means of an electronic light projector where the electronic light projector and material are moved relative to each other during exposure.

### DETAILED DESCRIPTION

The invention will now be described in more detail and by reference to the accompanying figures.
Figure 1 illustrates a system for solidification of photo polymerizable material layers in a 3D printer / rapid manufacturing machine or 2D lithography machine.
Figure 2 illustrates the exposure process performed by the system according to the invention.
Figure 3 illustrates an ideal situation during exposure where the brightness uniformity over the exposure image from the light projector is ideal, while the positioning of the adjacent exposure stripes are ideal.
Figure 4 illustrates a non-ideal situation during exposure where the brightness uniformity causes discontinuity in power between the adjacent exposure stripes.
Figure 5 illustrates a resulting power distribution after exposure of overlap zones by use of one embodiment of the system.
Figure 6 illustrates a resulting image distribution after exposure of overlap zones having offset in x and y by use of one embodiment of the system.
Figure 7 illustrates an example of a CAD image and a superimposed pattern exposed by the electronic light projector onto the material.
Figure 8 illustrates one example of a superimposed pattern on the sides of an image to be exposed.
Figure 9 illustrates another example of a superimposed pattern on the sides of an image to be exposed.
Figure 10 illustrates an example of how the CAD image is exposed to the photosensitive material using two exposure stripes from the image projector
Figure 11 illustrates an example of exposure of two adjacent images causing non-exposed areas on the edge between the exposure stripes.
Figure 12 illustrates another example of exposure of two adjacent images causing non-exposed areas on the edge between the exposure stripes.

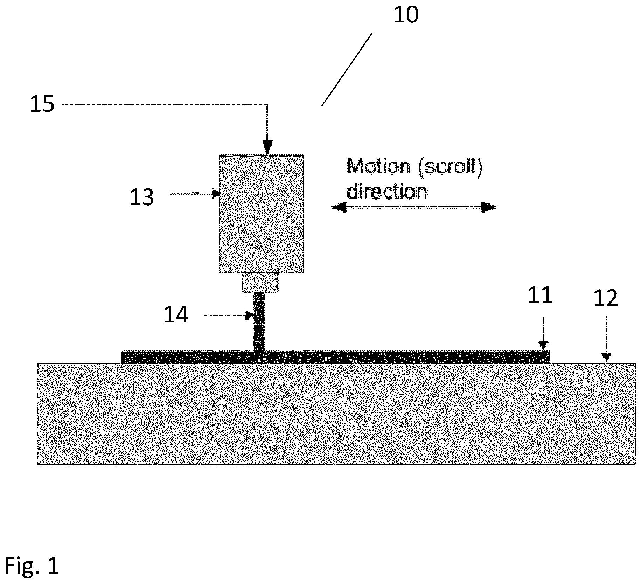

In figure 1 it is illustrated a system 10 for exposing a photosensitive or photo polymerizable material 11 layer by layer to build a 3D object or for 2D direct imaging lithography.

The system comprises an exposure table 12 and an electronic light projector 13 arranged above the exposure table 12. The electronic light projector 13 can emit light 14 towards the exposure table 12 and thus onto any medium 11 arranged on the exposure table 12, thereby projecting an image onto the medium. The medium 11 is for example a photosensitive or photo polymerizable material. The electronic light projector 13 moves relative to the exposed material 11, while a synchronization signal 15 is provided by a motor controller to enable the projector to set up the next image in an image sequence.

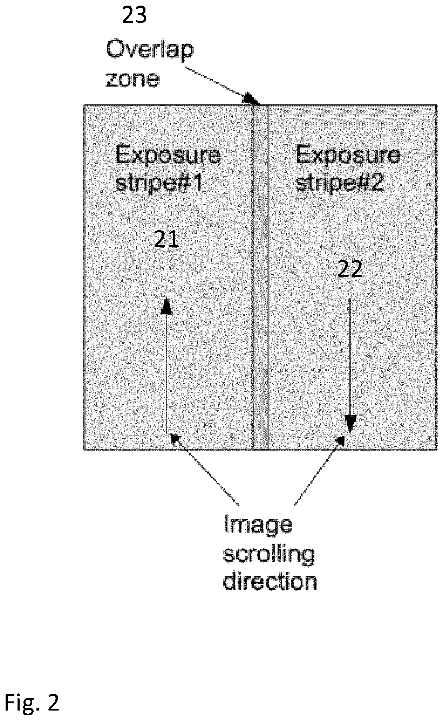

The electronic light projector comprises a space modulator e.g. a DLP/LCD/LCOS or similar light/power projector which acts as the curing light/power source for the solidification of photo polymerizable material layers in a 3D printer/rapid manufacturing machine or 2D lithography machine (Direct Imaging exposure machine). The process is executed as the projected image is in motion relative to the exposed material, thereby creating adjacent data exposure stripes, as illustrated in figure 2. The exposure stripes 21, 22 overlap slightly, thus providing an overlap zone 23.

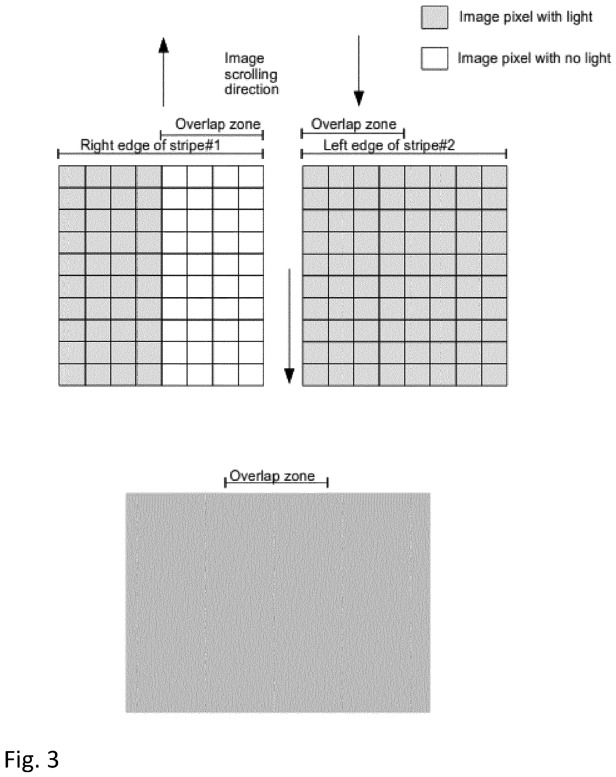

The power distribution over the image (brightness uniformity) is a critical parameter for projectors used in motion systems when multiple exposure stripes are required. Figure 3 illustrates an ideal situation where the power and image positioning are correctly aligned, thus providing a uniform combined exposed image 30.

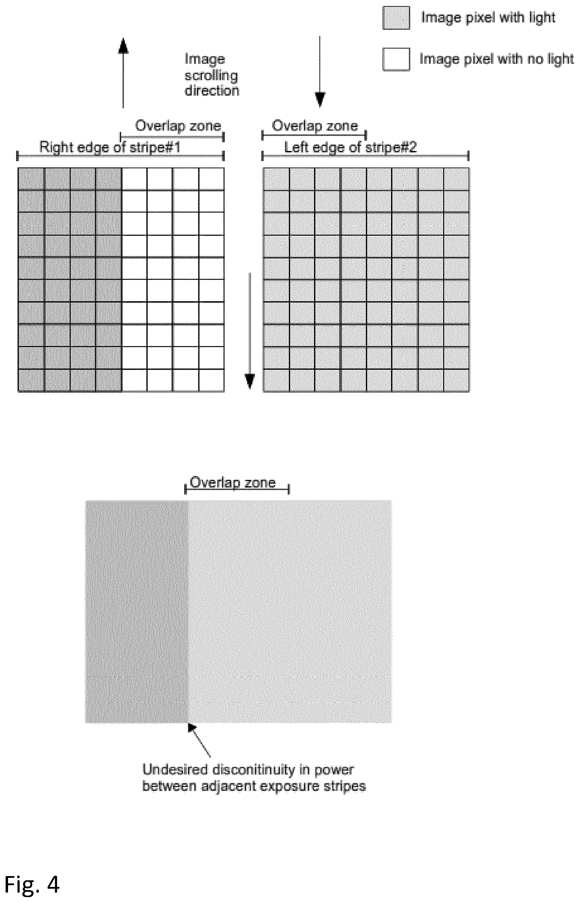

If the brightness uniformity is not within certain tolerances, depending on the sensitivity of the exposed material, this will be very noticeable when comparing with the adjacent exposure stripe, either if one or multiple projectors are used. This will provide a discontinuous step 41 in the polymerized result of the exposed material on the edge between the adjacent stripes. Figure 4 illustrates this situation.

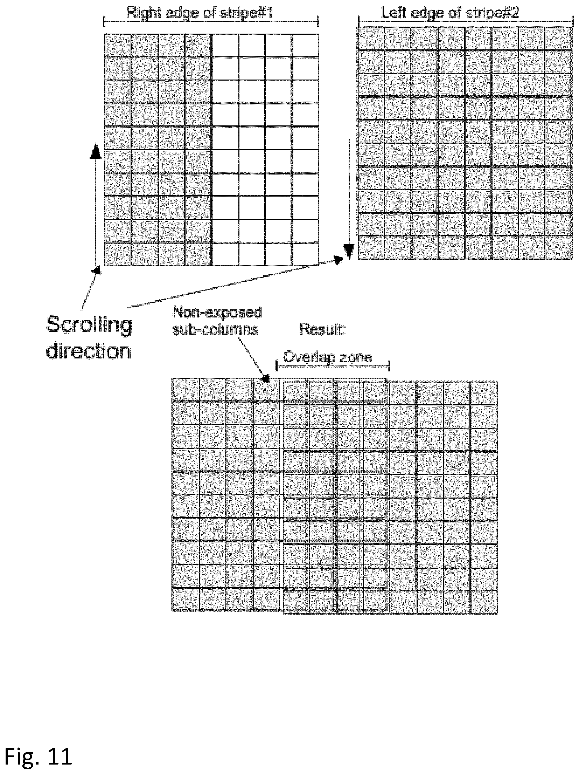

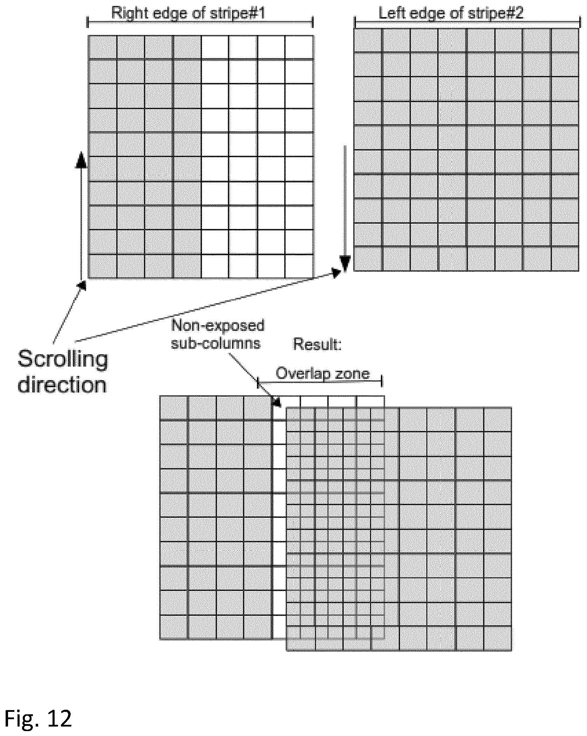

Also, if the mechanical alignment tolerances of the projector(s) relative to the exposed material is not a fraction of a projected pixel size, there will be an offset in image in both x- and y-direction between the exposure stripes. This will cause non-exposed areas or over-exposed areas on the edge between the exposure stripes if the adjacent exposure stripes are overlapping. Examples of such situations are illustrated in figures 11 and 12.

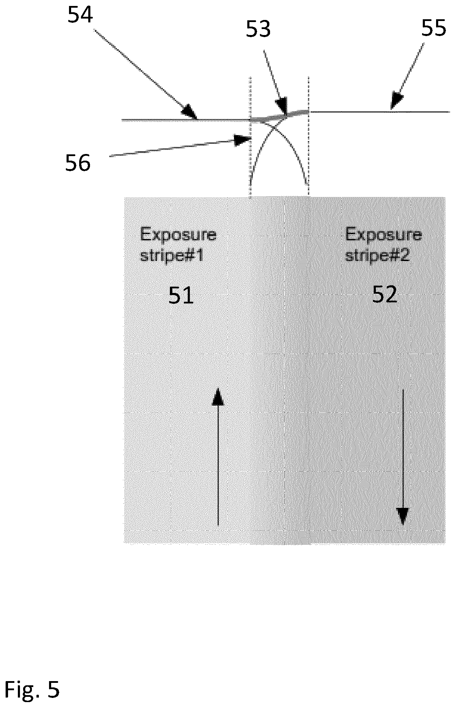

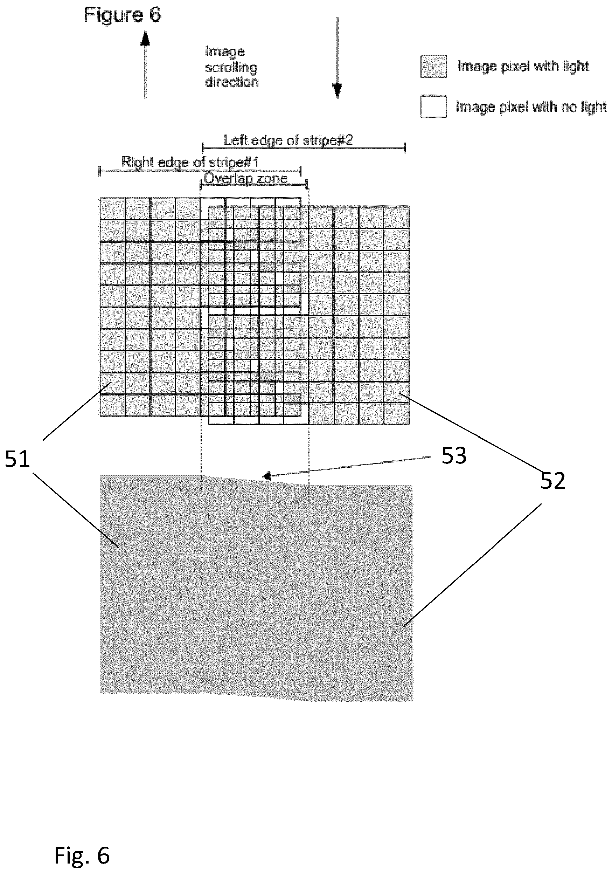

When exposure during motion in a motion system covers areas wider than the images by moving in both y-direction and x-direction on the machine, the process will smear out the power difference, and image offset difference between the exposure stripes are smeared over a shared zone between the exposure stripes. This can be called an edge blending area. This smearing will ensure that any difference in power or pixel edge between the exposure stripes will not have a discontinuous character, but a continuous character. Figure 5 and Figure 6 illustrates this situation. The example in the figures shows two exposure stripes 51, 52, where the projected image of the second stripe 52 is offset in both x- and y-direction relative to the projected image of the first stripe 51. The image in the overlap zone 53 is thus a blending of the edges of the two image stripes, where the power distribution in the overlap zone is smeared out. In figure 5 the power curves 54, 55 representing the two exposure stripes 51, 52 are illustrated. The resulting power curve 53 of the overlap zone is thus a smooth, continuous curve. This continuous character will improve the exposure result quality. The process can also be used when multiple light projectors are used in the same system with only one axis (y axis) or with two axes (x and y axis), creating adjacent exposure stripes.

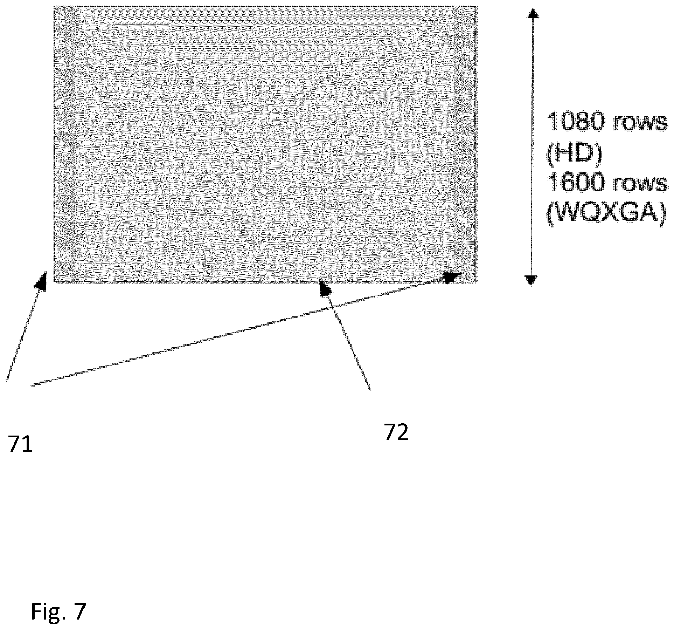

Figure 7 illustrates an example of an image exposed by the electronic light projector onto the material. The image may for example be in form of CAD (Computer aided design) image data 72 with a static image pattern 71 superimposed on to the data pattern given by the CAD file on each side of the image area. The width of the static image pattern 71 can be varied, depending on the requirements of the particular application. In extreme cases, the width of the pattern can be as wide as the image or exposure stripe (this case is not covered by the subject-matter of the claims), while minimum width is one image pixel. Typically, the pattern width will be the same as general tolerances for mechanical equipment for use in such applications, i.e. 20-200µm

The superimposed pattern is undergoing a logical "AND" operation with the data pattern given by the CAD file on a pixel by pixel basis as the CAD file data pattern is scrolling over the projector image synchronized with the relative motion of the table where the exposed material is placed.

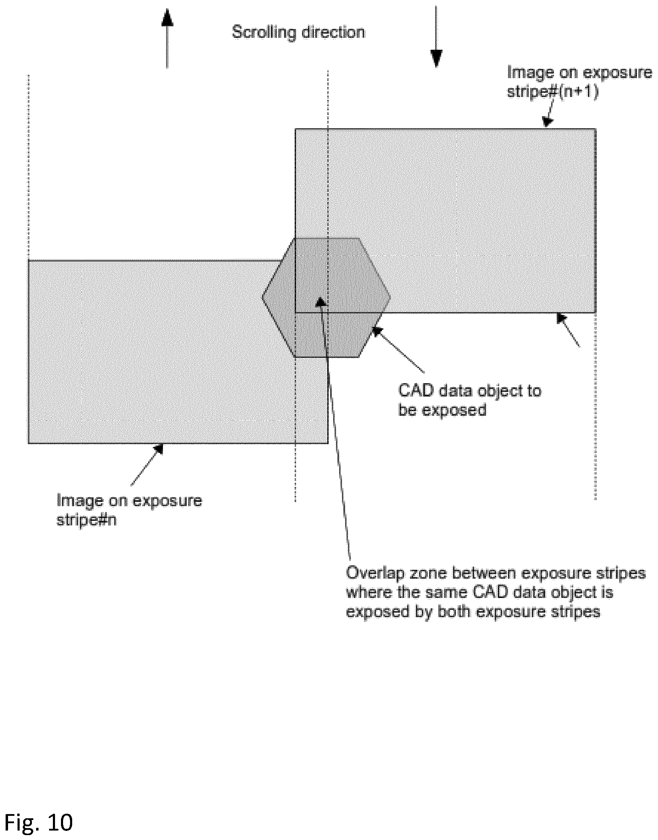

The sides 71 of the image area constitute an intentional overlap zone between the adjacent exposure stripes. The part of the image that is included in the overlapping zone contains a superimposed image pattern. The data pattern given by the CAD file will be identical on the adjacent exposure stripes inside the overlapping zone, so that right side of a first exposure stripe inside the overlapping zone is identical to left side of a second exposure stripe inside the overlapping zone. The overlapping CAD data between adjacent image stripes is also described in figure 10.

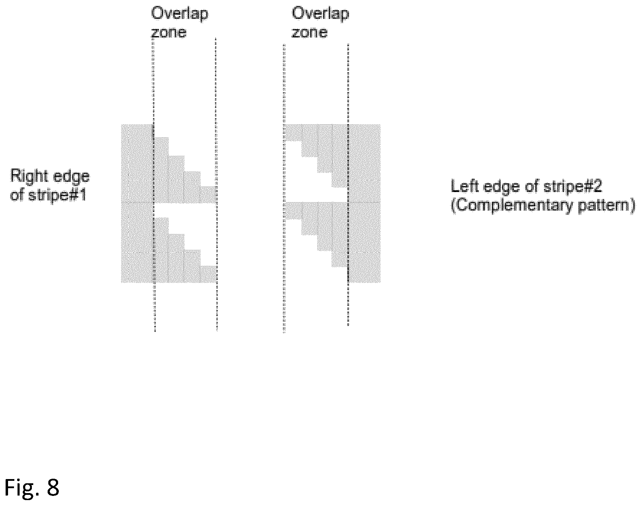

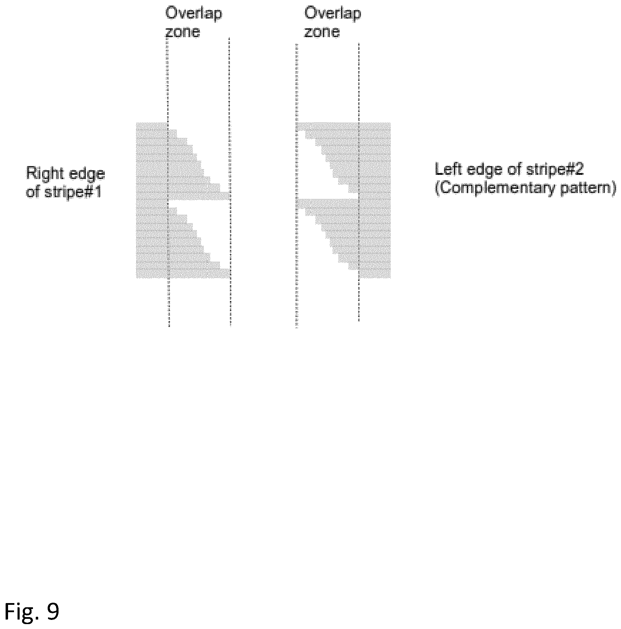

Figure 8 and 9 shows two examples of possible shapes of the superimposed pattern.

The figures illustrate a section of both the right side of a first exposure stripe and the left side of a second exposure stripe. The superimposed patterns on each side are complementary shaped as described in figure 8 and figure 9. This ensures uniform power distributing in the overlap zone.

The superimposed pattern can be customized depending of the character of the exposed polymerized material, in order to get the best continuous exposure result in the area between the exposure stripes. The pattern may be repeated over the image stripe length as shown in figures 7 to 9.

The superimposed pattern in the image overlap zone between the two adjacent exposure stripes may vary in size (overlapping zone width) orthogonal to the stripe length, depending on the extent of the desired edge blending.

The superimposed pattern length along the exposures stripe direction is limited by the number of rows in one 1 image (1 DMD height). In the example of figure 7, the number is 1080 (HD) or 1600 (WQXGA), but other image resolutions, such as 2160 (4k) can also be used.

During the exposure, the superimposed pattern may be fixed while the data pattern given by the CAD file is scrolling/sequentially exposed according to the relative movement between the exposed material and the projector.

The superimposed pattern may be preprogrammed and superimposed by a projector control unit, which may be connected to or comprised in the projector. The control system may in one embodiment be programmed in an external PC which controls the projector.

The exposed result by using the system according to the invention provides a continuous power transition between adjacent exposure stripes and a continuous position transition between the adjacent exposure stripes.

## Claims

1. System (10) for exposing a material (11) with images, where the system comprises an exposure table (12) and an electronic light projector (13) arranged above the exposure table (12) and being adapted to project images towards a material arranged at the exposure table (12), where the electronic light projector and the exposure table are configured to be moved relative to each other during exposure and where the electronic light projector (13) is connected to a projector control unit configured to:
- provide a sequence of images to be exposed represented by image data (72),
- superimpose a static image pattern (71) onto the edge sections of the images to be exposed, where the width of the static image pattern is slimmer than the image to be exposed, resulting in a sequence of combined images, and
where the electronic light projector (13) is configured to expose the combined images sequentially onto the material.

2. System according to claim 1, where the images to be exposed are in form of CAD (Computer aided design) image data (72) with a static image pattern (71) superimposed on to the data pattern given by the CAD file on each side of the image area.

3. System according to claim 1, where the material (11) is a photosensitive or photo polymerizable material.

4. System according to claim 1, where the electronic light projector (13) is connected to a motor controller providing a synchronization signal (15) to the electronic light projector for controlling the movement of the electronic light projector relative to the exposure table, in order to enable the projector to set up the next image in an image sequence.

5. System according to claim 1, where the superimposed pattern is fixed while the image data is sequentially presented.

6. System according to claim 1, where the superimposed pattern on one side of an exposure stripe is complementary to the other side of an adjacent exposure stripe.

7. System according to claim 1, where the projector control unit is configured to control the superimposition of the static image pattern onto the images to be exposed.

8. System according to claim 1, where the superimposed pattern has a width between a full projected image width and one projected image pixel

9. System according to claim 1, where the superimposed pattern has a length corresponding to number of rows in one projected image.

10. System according to claim 1, where the superimposed pattern is sawtooth shaped.

11. System according to claim 10, where the superimposed pattern is stepped sawtooth shaped.

12. Method for exposing a material with images, comprising the following steps:
- providing a sequence of images to be exposed,
- superimposing a static image pattern onto the edge sections of the images to be exposed, where the width of the static image pattern is slimmer than the image to be exposed, resulting in a sequence of combined images,
- exposing the combined images sequentially onto the material by means of an electronic light projector where the electronic light projector and material are moved relative to each other during exposure.

13. Method according to claim 12, where the images to be exposed are in form of CAD (Computer aided design) image data (72) with a static image pattern (71) superimposed on to the data pattern given by the CAD file on each side of the image area.

14. Method according to claim 12, comprising providing a synchronization signal (15) to the electronic light projector for controlling the movement of the electronic light projector relative to the exposure table, in order to enable the projector to set up the next image in an image sequence.

15. Method according to claim 12, controlling the sequence of images to be exposed.

## Patentansprüche

1. System (10) zum Belichten eines Materials (11) mit Bildern, wobei das System einen Belichtungstisch (12) und einen elektronischen Lichtprojektor (13) umfasst, der über dem Belichtungstisch (12) angeordnet und dazu ausgelegt ist, Bilder in Richtung eines Materials zu projizieren, das auf dem Belichtungstisch (12) angeordnet ist, wobei der elektronische Lichtprojektor und der Belichtungstisch dazu konfiguriert sind, während einer Belichtung relativ zueinander bewegt zu werden, und wobei der elektronische Lichtprojektor (13) mit einer Projektorsteuereinheit verbunden ist, die konfiguriert ist zum:
- Bereitstellen einer Sequenz von zu belichtenden Bildern, dargestellt durch Bilddaten (72),
- Überlagern der Kantenabschnitte der zu belichtenden Bilder mit einem statischen Bildmuster (71), wobei die Breite des statischen Bildmusters kleiner als das zu belichtende Bild ist, was zu einer Sequenz von kombinierten Bildern führt, und wobei der elektronische Lichtprojektor (13) dazu konfiguriert ist, die kombinierten Bilder sequenziell auf dem Material zu belichten.

2. System nach Anspruch 1, wobei die zu belichtenden Bildern die Form von Computer-Aided-Design(CAD)-Bilddaten (72) aufweisen, wobei das Datenmuster, das durch die CAD-Datei gegeben ist, auf jeder Seite des Bildbereichs mit einem statischen Bildmuster (71) überlagert ist.

3. System nach Anspruch 1, wobei das Material (11) ein photosensitives oder photopolymerisierbares Material ist.

4. System nach Anspruch 1, wobei der elektronische Lichtprojektor (13) mit einer Motorsteuerung verbunden ist, die dem elektronischen Lichtprojektor ein Synchronisationssignal (15) zum Steuern der Bewegung des elektronischen Lichtprojektors relativ zu dem Belichtungstisch bereitstellt, um es dem Projektor zu ermöglichen, das nächste Bild in einer Bildsequenz einzustellen.

5. System nach Anspruch 1, wobei das überlagerte Muster fest ist, während die Bilddaten sequenziell dargestellt werden.

6. System nach Anspruch 1, wobei das überlagerte Muster auf einer Seite eines Belichtungsstreifens komplementär zu der anderen Seite eines benachbarten Belichtungsstreifens ist.

7. System nach Anspruch 1, wobei die Projektorsteuereinheit dazu konfiguriert ist, das Überlagern der zu belichtenden Bilder mit dem statischen Bildmuster zu steuern.

8. System nach Anspruch 1, wobei das überlagerte Muster eine Breite zwischen einer vollen Breite eines projizierten Bilds und einem projizierten Bildpixel aufweist.

9. System nach Anspruch 1, wobei das überlagerte Muster eine Länge aufweist, die der Anzahl von Zeilen in einem projizierten Bild entspricht.

10. System nach Anspruch 1, wobei das überlagerte Muster sägezahnförmig ist.

11. System nach Anspruch 10, wobei das überlagerte Muster gestuft sägezahnförmig ist.

12. Verfahren zum Belichten eines Materials mit Bildern, umfassend die folgenden Schritte:
- Bereitstellen einer Sequenz von zu belichtenden Bildern,
- Überlagern der Kantenabschnitte der zu belichtenden Bilder mit einem statischen Bildmuster, wobei die Breite des statischen Bildmusters kleiner als das zu belichtende Bild ist, was zu einer Sequenz von kombinierten Bildern führt,
- sequenzielles Belichten der kombinierten Bilder auf dem Material durch einen elektronischen Lichtprojektor, wobei der elektronische Lichtprojektor und das Material während einer Belichtung relativ zueinander bewegt werden.

13. Verfahren nach Anspruch 12, wobei die zu belichtenden Bildern die Form von Computer-Aided-Design(CAD)-Bilddaten (72) aufweisen, wobei das Datenmuster, das durch die CAD-Datei gegeben ist, auf jeder Seite des Bildbereichs mit einem statischen Bildmuster (71) überlagert ist.

14. Verfahren nach Anspruch 12, umfassend Bereitstellen eines Synchronisationssignals (15) für den elektronischen Lichtprojektor zum Steuern der Bewegung des elektronischen Lichtprojektors relativ zu dem Belichtungstisch, um es dem Projektor zu ermöglichen, das nächste Bild in einer Bildsequenz einzustellen.

15. Verfahren nach Anspruch 12, Steuern der Sequenz der zu belichtenden Bilder.

## Revendications

1. Système (10) d'exposition d'un matériau (11) à des images, où le système comprend une table d'exposition (12) et un projecteur de lumière électronique (13) agencé au-dessus de la table d'exposition (12) et étant apte à projeter des images vers un matériau agencé au niveau de la table d'exposition (12), où le projecteur de lumière électronique et la table d'exposition sont configurés pour être déplacés l'un par rapport à l'autre au cours d'une exposition et où le projecteur de lumière électronique (13) est relié à une unité de commande de projecteur configurée pour :
- fournir une séquence d'images à exposer représentées par des données d'image (72),
- superposer un motif d'image statique (71) sur les sections de bord des images à exposer, où la largeur du motif d'image statique est plus mince que l'image à exposer, en engendrant une séquence d'images combinées, et
où le projecteur de lumière électronique (13) est configuré pour exposer séquentiellement les images combinées sur le matériau.

2. Système selon la revendication 1, où les images à exposer sont sous la forme de données d'image (72) de CAO (conception assistée par ordinateur) avec un motif d'image statique (71) superposé sur le motif de données donné par le fichier de CAO sur chaque côté de l'aire d'image.

3. Système selon la revendication 1, où le matériau (11) est un matériau photosensible ou photopolymérisable.

4. Système selon la revendication 1, où le projecteur de lumière électronique (13) est relié à un dispositif de commande de moteur fournissant un signal de synchronisation (15) au projecteur de lumière électronique pour commander le déplacement du projecteur de lumière électronique par rapport à la table d'exposition, afin de permettre au projecteur de mettre en place l'image suivante dans une séquence d'images.

5. Système selon la revendication 1, où le motif superposé est fixe pendant que les données d'image sont présentées séquentiellement.

6. Système selon la revendication 1, où le motif superposé sur un côté d'une bande d'exposition est complémentaire de l'autre côté d'une bande d'exposition adjacente.

7. Système selon la revendication 1, où l'unité de commande de projecteur est configurée pour commander la superposition du motif d'image statique sur les images à exposer.

8. Système selon la revendication 1, où le motif superposé présente une largeur entre une largeur d'image projetée complète et un pixel d'image projetée.

9. Système selon la revendication 1, où le motif superposé présente une longueur correspondant à un nombre de rangées dans une image projetée.

10. Système selon la revendication 1, où le motif superposé est de forme en dents de scie.

11. Système selon la revendication 10, où le motif superposé et de forme en dents de scie étagée.

12. Procédé d'exposition d'un matériau à des images, comprenant les étapes suivantes :
- la fourniture d'une séquence d'images à exposer,
- la superposition d'un motif d'image statique sur les sections de bord des images à exposer, où la largeur du motif d'image statique est plus mince que l'image à exposer, en engendrant une séquence d'images combinées,
- l'exposition séquentiellement des images combinées sur le matériau au moyen d'un projecteur de lumière électronique, où le projecteur de lumière électronique et le matériau sont déplacés l'un par rapport à l'autre au cours d'une exposition.

13. Procédé selon la revendication 12, où les images à exposer sont sous la forme de données d'image (72) de CAO (conception assistée par ordinateur) avec un motif d'image statique (71) superposé sur le motif de données donné par le fichier de CAO sur chaque côté de l'aire d'image.

14. Procédé selon la revendication 12, comprenant la fourniture d'un signal de synchronisation (15) au projecteur de lumière électronique pour commander le déplacement du projecteur de lumière électronique par rapport à la table d'exposition, afin de permettre au projecteur de mettre en place l'image suivante dans une séquence d'images.

15. Procédé selon la revendication 12, commandant la séquence d'images à exposer.
